(19) **Europäisches Patentamt / European Patent Office / Office européen des brevets**

(11) **EP 2 724 216 B1**

(12) # FASCICULE DE BREVET EUROPEEN

(45) Date de publication et mention de la délivrance du brevet:
**12.08.2015 Bulletin 2015/33**

(21) Numéro de dépôt: **13714869.8**

(22) Date de dépôt: **08.03.2013**

(51) Int Cl.:
**G06F 3/041** (2006.01)  **G06F 3/044** (2006.01)

(86) Numéro de dépôt international:
**PCT/EP2013/054729**

(87) Numéro de publication internationale:
**WO 2013/135575 (19.09.2013 Gazette 2013/38)**

(54) **PROCEDE DE MESURE CAPACITIVE PAR DES ELECTRODES NON-REGULIERES, ET APPAREIL METTANT EN OEUVRE UN TEL PROCEDE**

VERFAHREN ZUR KAPAZITIVEN MESSUNG DURCH NICHTREGULÄRE ELEKTRODEN UND VORRICHTUNG ZUR DURCHFÜHRUNG DIESES VERFAHRENS

METHOD OF CAPACITIVE MEASUREMENT BY NONREGULAR ELECTRODES, AND APPARATUS IMPLEMENTING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.03.2012 FR 1252271**

(43) Date de publication de la demande:
**30.04.2014 Bulletin 2014/18**

(73) Titulaire: **Nanotec Solution**
**30900 Nîmes (FR)**

(72) Inventeur: **LUONG, Bruno**
**F-30900 Nîmes (FR)**

(74) Mandataire: **Pontet Allano & Associes**
**Parc Les Algorithmes, Bâtiment Platon**
**CS 70003 Saint-Aubin**
**91192 Gif-sur-Yvette Cedex (FR)**

(56) Documents cités:
**US-A1- 2003 132 922     US-A1- 2010 013 800**
**US-B1- 6 348 862**

Printed by Jouve, 75001 PARIS (FR)

**Description**

La présente invention concerne un procédé de mesure capacitive absolue (self capacitance) d'un objet à proximité d'une pluralité d'électrodes indépendantes, ces électrodes présentant des surfaces non-régulières. Elle concerne aussi un appareil électronique d'interface gestuel mettant en oeuvre le procédé.

Le domaine de l'invention est plus particulièrement mais de manière non limitative celui des surfaces tactiles et 3D capacitives utilisées pour les commandes d'interface homme machine.

De plus en plus d'appareils de communication et de travail utilisent une interface de commande tactile comme un pad ou un écran. On peut citer par exemple les téléphones mobiles, smartphones, ordinateurs à écran tactile, pads, PC, souris, dalles tactiles, écrans géants.....

Un grand nombre de ces interfaces utilisent les technologies capacitives.

La surface tactile est équipée d'électrodes conductrices reliées à des moyens électroniques qui permettent de mesurer la variation des capacités apparaissant entre des électrodes et l'objet à détecter pour effectuer une commande.

Les techniques capacitives actuellement mises en oeuvre dans des interfaces tactiles utilisent le plus souvent deux couches d'électrodes conductrices en forme de lignes et de colonnes. La topologie géométrie la plus répandue est que chaque ligne et chaque colonne se compose de losanges qui se relient dans la direction verticale pour former une colonne et dans la direction horizontale pour former une ligne.

Sur cette topologie géométrique deux modes de fonctionnement peuvent être déclinés pour détecter la présence d'un objet devant la surface :

1. L'électronique mesure les capacités de couplage qui existent entre ces lignes et colonnes. Lorsqu'un doigt est très proche de la surface active, les capacités de couplage à proximité du doigt sont modifiées et l'électronique peut ainsi localiser la position en 2D (XY), dans le plan de la surface active. Ces technologies permettent de détecter la présence et la position du doigt au travers d'un diélectrique. Elles ont l'avantage de permettre une très bonne résolution dans la localisation dans le plan (XY) de la surface sensible d'un ou de plusieurs doigts. Ces techniques ont toutefois l'inconvénient de générer par principe des capacités de fuite importantes au niveau des électrodes et de l'électronique. Ces capacités de fuite peuvent de plus dériver dans le temps du fait du vieillissement, de la déformation des matériaux, ou de l'effet de la variation de la température environnante. Ces variations peuvent dégrader la sensibilité des électrodes, voire déclencher intempestivement des commandes. Un autre inconvénient de cette technique est que : le champ électrique généré entre les lignes et les colonnes reste concentré surtout autour de la surface et le changement de capacité de couplage ne se produit uniquement pour des objets très proche de la surface, voir en contact. Ce qui limite cette technique à une utilisation tactile et 2D exclusivement.

2. L'électronique mesure - pour chaque ligne et chaque colonne d'électrode- la capacité absolue qui apparaît entre l'objet et l'électrode en question. L'avantage de cette méthode est que le champ électrique se radie plus loin de la surface, permettant de mesurer les objets qui se trouvent à plusieurs centimètres au-dessus de l'écran. L'inconvénient de cette méthode est la limitation de détecter plusieurs objets à cause d'une ambiguïté de positions des deux objets, en effet si on permute les coordonnés X ou Y de ces objets, les capacitances mesurées seront identiques. Pour l'homme de l'art, ce phénomène est appelé la détection des fantômes (« ghosting » en anglais).

On connait également des techniques permettant de mesurer la capacité absolue qui apparait entre des électrodes et un objet à détecter. On connaît par exemple le document FR 2 844 349 de Rozière qui divulgue un détecteur capacitif de proximité comprenant une pluralité d'électrodes qui seront excités et mesuré de façon indépendantes. Ce détecteur permet de mesurer la capacité absolue et la distance entre les électrodes et les objets à proximité.

Ces techniques permettent d'obtenir des mesures de capacité entre les électrodes et les objets avec une résolution et une sensibilité élevées. Ceci permet de détecter par exemple un doigt à plusieurs centimètres de distance, sans ambiguïté. La détection peut se faire dans l'espace en trois dimensions (XYZ) mais également sur une surface, dans un plan (XY). Ces techniques ouvrent la possibilité de développer des interfaces gestuelles réellement sans contact, et permettent également d'améliorer les performances des interfaces tactiles.

Afin d'interpréter facilement les mesures, de détecter avec robustesse la présence d'un objet et d'estimer précisément sa position, les électrodes sont disposées idéalement de façon régulièrement sur la surface, ce qui conduit de préférence à disposer les électrodes dans une configuration à géométrie rectangulaire identique pour toutes les électrodes. La taille des électrodes est à peu près identique ou inférieur d'environ 50% de la taille de l'objet à détecter. Typiquement, une surface d'électrode allant de 0.35 à 0.65 cm$^2$ est bien adapté à une application de type interface humaine, où l'objet à détecter est un doigt humain. Ce type de partitionnement régulier est bien adapté pour des interfaces de type boutons 2D/3D virtuels où les électrodes sont gravées sur une carte électronique PCB (« Printed Circuit Board ») et sont alimentées par une alimentation qui réside en dessous de la couche conductrice de surface.

Cependant à cause des contraintes liées à la transparence des surfaces dans certaines applications de type « smartphone » où la surface de détection doit laisser passer un maximum de lumière provenant de l'affichage, la surface des électrodes ainsi que sa connexion électrique au circuit électronique d'excitation et d'acquisition sont disposées sur la même couche. Les connexions électriques permettent de relier les électrodes qui se trouvent au centre de l'écran jusqu'à la périphérie de l'écran, puis ces connexions descendent - si c'est nécessaire - le long de la circonférence de l'écran. Les connexions sur la circonférence peuvent être protégées électriquement ou non contre les perturbations capacitives de l'environnement en les recouvrant d'une surface isolante puis en disposant à proximité un conducteur dit de garde et qui est excité avec le même potentiel électrique que les électrodes. Si les pistes sont « gardées », elles sont considérées comme non-mesurant et ne sont pas considérées comme partie des mesures capacitives. Dans le cas contraire, ces pistes sont partie intégrante de la mesure. Les connexions qui relient les électrodes du centre vers la périphérie font que chaque mesure individuelle n'est plus localisée à une surface rectangulaire. Elle mesure une réponse non seulement lorsque l'objet est au dessus de la surface principale, mais dès que l'objet est à proximité de la piste de connexion qui peut se trouver éloignée de la surface principale de mesure.

Toutefois, la contrainte d'une meilleure transparence de l'écran oblige à disposer les électrodes et leurs connexions sur la même surface. Ceci permet de réduire le coût de fabrication. Cette simplification permet d'avoir une grande fiabilité en supprimant les éléments de connexion électrique inter-couches.

On connait le document US6348862B1 décrivant un système de plusieurs électrodes, une électrode de détection et plusieurs électrodes de commande, de façon à améliorer le rapport signal sur bruit. Pour ce faire, l'électrode de détection et les électrodes de commande sont alimentées par des signaux différents. Un troisième signal est détecté au niveau de l'électrode de détection de façon à élaborer plusieurs scénario de mesure.

Le document US 2003/0132922 décrit un procédé pour déterminer des coordonnées d'un point considéré comme le plus proche d'un point de contact en approche sur un écran tactile.

Le document US2010/0013800 décrit une interface tactile utilisant deux couches d'électrodes conductrices en forme de ligne et de colonnes de sorte que l'on mesure les capacités de couplage qui existent entre ces lignes et colonnes. Le document US2010/0013800 décrit une méthode de correction de capacités parasites pouvant exister au niveau des électrodes. Cette méthode est mise en oeuvre lors de la conception de l'écran par stimulation des électrodes, mesure des capacités parasites et application de coefficients de correction.

La présente invention a pour but un nouveau procédé de mesure limitant les perturbations dues aux pistes de connexion.

L'invention a encore pour but de réduire le coût de la conception d'un appareil comprenant une interface gestuelle homme-machine.

On atteint au moins l'un des objectifs avec un procédé de mesure capacitive absolue d'un objet par rapport à au moins deux électrodes indépendantes intégrées dans un dispositif d'interface homme-machine pour la détection dudit objet. Selon l'invention, ce procédé comprend les étapes suivantes :

a) pour chaque électrode, on mesure une valeur de capacité absolue entre l'électrode et l'objet,
a') on réalise une prédiction en appliquant un modèle multi-variables de prédiction non linéaire sur les valeurs réelles de capacité absolue de façon à obtenir une image de densités de probabilité (au moment de la mesure, en temps réel), ces densités de probabilité étant considérées comme des valeurs de capacité absolue corrigées que l'on utilise pour la détection dudit objet.

Avec un tel procédé selon l'invention, on utilise un modèle multi-variables de prédiction non linéaire pour corriger les valeurs réelles de capacité absolue. Cette correction permet de transformer ces valeurs réelles en des valeurs corrigées permettant de compenser différents défauts dans le design des électrodes. Ces défauts peuvent être dus à une forme géométrique non optimisée des électrodes, ce qui limiterait notamment la résolution dans la détection. Par exemple, cette forme géométrique peut être due à des pistes de connexion qui partiraient de la périphérie d'un plan d'électrodes vers des électrodes disposées dans la zone centrale du plan d'électrodes. Cette forme géométrique défavorable peut être qualifiée de surface non-régulière. Par surface non-régulière, on entend une surface qui ne présente pas une forme géométrique régulière telle un carré, un rectangle, un cercle ou toute autre forme. A titre d'exemple, une telle surface est une surface qui comprend un rectangle accolé à une fine bande telle une piste de connexion.

Comme on le verra plus loin, l'image de densités de probabilité peut être une image de valeurs virtuelles obtenu par mesure sur un plan d'électrodes idéal, ou une image de fonctions obtenues à partir d'une gaussienne pour un plan d'électrodes idéal. Ce plan d'électrodes idéal peut être un design théorique pour une disposition haute résolution des électrodes, avec un nombre et une forme des électrodes différents du nombre et forme des électrodes réelles.

De préférence, le modèle multi-variables de prédiction non linéaire est obtenu par régression non linéaire à partir :

- de valeurs réelles de capacité absolue obtenues pour une pluralité de positions d'objet par rapport auxdites au moins deux électrodes, et
- d'une image de densités de probabilité obtenue pour une pluralité de positions d'objet par rapport à des électrodes idéalisées.

La détermination par régression non linéaire peut être obtenue par un modèle des réseaux de neurones artificiels. Différentes façons de mettre en oeuvre les réseaux de neurones existent est sont à la portée de l'homme du métier.

De préférence, la présente invention prévoit la mise en oeuvre suivante : à l'étape a) on constitue un vecteur $V_{raw}$ à partir des valeurs de capacité absolue mesurées et la prédiction à l'étape a') comprend les étapes suivantes :

b) application d'une première transformation non-linéaire F2 sur au moins le vecteur $V_{raw}$ de façon à obtenir un vecteur X2,

c) application d'une transformation affine de façon à obtenir un vecteur Y2 en multipliant le vecteur X2 par une matrice M2 et en ajoutant un vecteur de translation Y02 ; la matrice M2 étant une matrice de transfert entre un vecteur de valeurs réelles de capacité absolue obtenues sur des électrodes de surface non-régulière en présence d'objet, et un vecteur de valeurs virtuelles obtenues pour des électrodes idéalisées en présence d'objet,

d) application sur au moins le vecteur Y2 d'une seconde transformation non-linéaire qui est inverse de la première transformation non-linéaire F2 de façon à obtenir un vecteur de correction V_corr, et

e) utilisation du vecteur de correction V_corr comme valeurs de capacité absolue pour la détection dudit objet.

Avec cette mise en oeuvre, on réalise une correction des valeurs de capacitance absolue mesurées. Ces valeurs ont été modifiées de façon à supprimer notamment l'influence des pistes de connexion, ces pistes de connexion étant la différence entre les électrodes réelles et les électrodes virtuelles. C'est par la matrice M2 et le vecteur de translation YO2 que l'on fait intervenir le modèle entre les électrodes réelles et les électrodes virtuelles considérées comme idéales.

L'objet qui se déplace dans un volume face ou à proximité des électrodes peut être détecté avec précision grâce au procédé selon l'invention. Cela permet d'envisager aisément la conception d'une matrice d'électrodes disposées sur une même couche que les connexions.

Selon une caractéristique avantageuse de l'invention, on peut mettre en oeuvre différentes fonction F2 telles que par exemple :

- $F2(V_{raw}) = 1/V_{raw}$
- $F2(V_{raw}) = 1/(V_{raw}/Vmax + \beta)$ , Vmax étant une tension maximum prédéterminée, et $\beta$ un nombre positif ; ou
- $F2(V_{raw}) = V_{raw}/Vmax$, Vmax étant une tension maximum prédéterminée.

Selon un mode de réalisation avantageux de l'invention, après l'étape a), on réalise les étapes suivantes :

filtrage, des valeurs du vecteur $V_{raw}$ de façon à obtenir un vecteur $V_{inf\_raw}$
- application d'une transformation non-linéaire F1 sur le vecteur $V_{inf\_raw}$ de façon à obtenir un vecteur X1,
- application d'une transformation affine de façon à obtenir un vecteur Y1 en multipliant le vecteur X1 par une matrice M1 et en ajoutant un vecteur de translation Y01 ; la matrice M1 étant une matrice de transfert entre un vecteur de valeurs réelles de capacité absolue obtenues sur des électrodes de surface non-régulière en absence d'objet de détection, et un vecteur de valeurs virtuelles en absence d'objet de détection, et
- application sur le vecteur Y1 d'une transformation non-linéaire qui est inverse de la transformation non-linéaire F1 de façon à obtenir un vecteur de correction Vinf_corr,
- puis réalisation des étapes b) à e), dans lesquelles, à l'étape b) on applique la transformation non-linéaire F2 sur les vecteurs $V_{raw}$ et $V_{inf\_raw}$ de façon à obtenir un vecteur X2 fonction de $V_{raw}$ et $V_{inf\_raw}$ ; et à l'étape d) on applique sur les vecteurs Y2 et Vinf_corr une seconde transformation non-linéaire qui est inverse de la première transformation non-linéaire F2 de façon à obtenir un vecteur de correction V_corr qui est fonction de Y2 et Vinf_corr.

Avec un tel mode de réalisation, on corrige d'abord un ensemble de valeurs relatives aux électrodes réelles sans prise en compte de l'objet d'intérêt, c'est le filtrage qui permet d'éliminer l'influence de l'objet d'intérêt. La seconde correction se sert des résultats de la première correction pour corriger les valeurs relatives aux électrodes réelles avec prise en compte de l'objet d'intérêt.

Selon l'invention, la fonction F1 peut également prendre différèntes formes telles que :

- $F1(V_{raw}) = 1/V_{raw}$.
- $F1(V_{raw}) = 1/(V_{raw}/Vmax + \beta)$, max étant une tension maximum prédéterminée, et $\beta$ un nombre positif, ou
- $F1(V_{raw}) - V_{raw}/Vmax$, Vmax étant une tension maximum prédéterminée.

Dans ce mode de réalisation, la fonction F2 peut être telle que :

- F2($V_{raw}$ , $V_{inf*}$) = $V_{raw}/V_{inf*}$ ; $V_{inf*}$ étant égal à $V_{inf\_raw}$ lors de la transformation non linéaire à l'étape b), et égal à $V_{inf\_corr}$ lors de la transformation non linéaire inverse à l'étape d), ou
- F2($V_{raw}$ , $V_{inf*}$) = 1-($V_{raw}/V_{inf*}$) ; $V_{inf*}$ étant égal à $V_{inf\_raw}$ lors de la transformation non linéaire à l'étape b), et égal à $V_{inf\_corr}$ lors de la transformation non linéaire inverse à l'étape d).

On peut également envisager au cours de l'étape e) une étape de normalisation du vecteur de correction V_corr au cours de laquelle on réalise les étapes suivantes :

- filtrage du vecteur de correction V_corr pour obtenir un vecteur filtré V_corr_f, et
- normalisation du vecteur de correction avec le vecteur filtré filtré V_corr_f de façon à obtenir un vecteur normalisé V_corr_nor.

Selon une caractéristique avantageuse de l'invention, le filtrage est obtenu selon l'une des formules suivantes :

V(t0) = max { V(t) : t ∈ (-∞, t0) } ; t0 étant l'instant de la mesure, V(t) étant le vecteur sur lequel s'applique le filtrage, t étant l'indice temporel, ou
V(t0) = max { V(t) : t ∈ (t0 - *windowsize*, t0) }, avec *windowsize* une période temporelle de la fenêtre de l'auto-calibration - c'est-à-dire période temporelle dans laquelle toute perturbation inchangée sera considérée comme causée par un objet de non-intérêt - t0 étant l'instant de la mesure, V(t) étant le vecteur sur lequel s'applique le filtrage, t étant l'indice temporel.

Le filtrage peut également être obtenu en remplaçant simplement le vecteur sur lequel s'applique le filtrage par un vecteur prédéterminé.
Selon l'invention, la matrice M peut être obtenue par la méthode des moindres carrés partiels, le vecteur de valeurs virtuelles étant un vecteur de valeurs obtenues pour des électrodes idéalisées. Il s'agit d'électrodes régulières ne comportant de piste de connexion distante.
Autrement, on peut prévoir d'obtenir la matrice M à partir d'un échantillonnage d'une fonction de densité de probabilité issue d'une multitude de positions exactes d'objet par rapport aux électrodes, le vecteur de valeurs virtuelles étant un vecteur dont les valeurs sont des probabilités de présence. Dans ce cas, la fonction de densité de probabilité peut avantageusement être une gaussienne 2D centrée sur chaque position horizontale d'objet, dont la largeur dépend de la position vertical de l'objet, cette gaussienne étant définie par la formule suivante :

$$ Gj(t) = A(z0) * exp[ - ((xj - xo)^2 + (yj - yo)^2) / \sigma(z0)^2 ], $$

où : (xj,yj) sont des coordonnées d'une grille régulière sur une surface de détection comprenant les électrodes ; (xo(t),yo(t),zo(t)) sont des coordonnées 3D de l'extrémité de l'objet la plus proche de la surface de détection ; A(zo) et $\sigma$(zo) sont deux fonctions prédéterminées dépendant de la distance z0 de façon monotone, A(z) étant décroissante et $\sigma$(zo) croissante.
Selon un autre aspect de l'invention, il est prévu un appareil électronique comprenant :

- deux électrodes indépendantes intégrées dans un dispositif d'interface homme-machine
- une unité de traitement pour détecter la position d'un objet par mesure de la capacité absolue dudit objet par rapport aux électrodes. Selon l'invention, l'unité de traitement est configurée pour mettre en oeuvre au moins l'une des étapes décrites ci-dessus.

L'appareil peut comprendre un écran tactile ou non.
De façon générale, la détection peut être une détection sur deux dimensions sur un écran ou une détection de la gestuelle dans un volume en trois dimensions à proximité d'un écran ou non (par exemple une dalle de détection disposée derrière une lame en bois,...).
Une réalisation de l'électronique de cette présente invention peut être celle décrite par le brevet WO 2011/015795 A1. Dans cette réalisation, une garde active a été mise en place pour minimiser la fuite capacitive et assurer une meilleure qualité de mesure des objets d'intérêt. Si la garde active n'est pas présentée, la fuite capacitive devrait être calibrée et retranchée.
Les électrodes sont de préférence conçues à partir de l'oxyde d'indium dopé à l'étain (ITO). D'autres matériaux transparents à la lumière comme l'oxyde de zinc dopé de l'aluminium (AZO) ou de l'oxyde de cadmium dopé à l'étain peuvent aussi être utilisés.

D'autres avantages et caractéristiques de l'invention apparaîtront à l'examen de la description détaillée d'un mode de mise en oeuvre nullement limitatif, et des dessins annexés, sur lesquels :

- Les figures 1a et 1b sont des vues schématiques d'un appareil selon l'invention ;
- La figure 2 est une vue schématique illustrant la variation du potentiel électrique en fonction du déplacement d'un objet d'intérêt au dessus d'un appareil selon l'invention ;
- Les figures 3a et 3b sont des vues schématiques illustrant d'une part des électrodes réelles avec un découpage irrégulier, et d'autre part des électrodes virtuelles avec un découpage régulier de la surface ;
- La figure 4 est une vue schématique illustrant des électrodes virtuelles circulaires :
- Les figures 5a et 5b sont des vues schématiques illustrant d'une part des électrodes réelles avec un découpage irrégulier, et d'autre part des électrodes virtuelles avec un découpage régulier de la surface mais avec une plus grande concentration d'électrodes vers les bords ;
- La figure 6 est une vue schématique illustrant un appareil de type « smartphone » selon l'invention ;
- Les figures 7a et 7b sont respectivement une vue schématique illustrant des électrodes réelles numérotées et un zoom schématique sur l'une des électrodes ;
- La figure 8 est une vue schématique illustrant un organigramme d'étapes selon l'invention ; et
- la figure 9 est une vue schématique du procédé général selon l'invention.

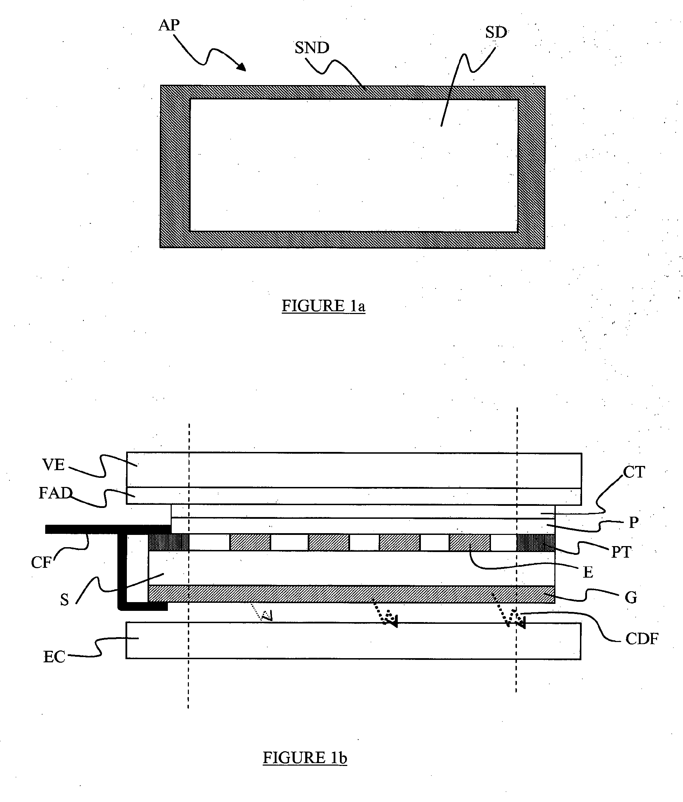

De façon générale, sur les figures 1a et 1b, on voit un appareil AP selon l'invention. Il peut s'agir d'un téléphone de type « smartphone » ou d'une tablette numérique dotée d'un écran tactile. Cet appareil AP comprend une surface de détection SD qui est la partie tactile sous laquelle se trouve notamment un plan (plat ou courbé) d'électrodes. Cette surface de détection SD comprend depuis la partie supérieure, plusieurs couches en matériau transparent telles que par exemple :

- une vitre externe VE,
- un film anti-débris FAD,
- une colle transparente CT, et
- un polariseur P,
- des électrodes E en matériau transparent conducteur tel que l'oxyde d'indium dopé à l'étain (ITO),
- un support S en verre pour électrodes,
- une garde G qui est une couche en matériau transparent conducteur tel que l'oxyde d'indium dopé à l'étain (ITO), et
- un écran EC d'affichage qui doit être visible de l'extérieur depuis la vitre externe VE.

Les électrodes et la garde se trouvent donc sous la surface de détection et sont en matériau transparent conducteur qui présente une haute résistivité.

On distingue également une surface de non détection SND qui entoure dans le cas d'espèce la surface de détection SD. Cette surface est généralement opaque de l'extérieur et ne comporte pas d'électrodes mais des pistes de connexion PT et des connecteurs flexibles CF qui sont métalliques donc de résistivité quasiment nulle.

Bien que l'invention n'y soit pas limitée, on va maintenant décrire un procédé selon l'invention dans lequel la régression et la prédiction font intervenir trois transformations: une transformation non linéaire, une transformation linéaire, puis une seconde transformation non linéaire: Comme précisé précédemment, d'autres techniques peuvent être utilisées dans la famille notamment des réseaux de neurones.

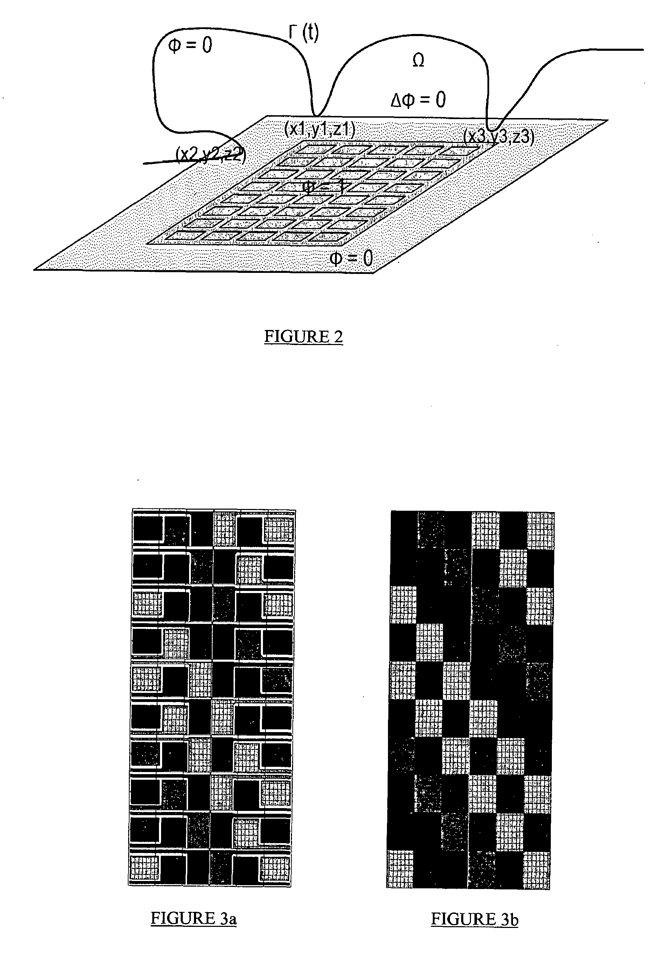

La présente invention peut être mise en oeuvre dans une première phase d'étalonnage pour déterminer des matrices et vecteurs de translation d'une transformation affine. Selon un mode de réalisation, on élabore un modèle entre des valeurs de capacitance absolue réelle et des valeurs de capacitance absolue virtuelle. Par définition, la capacitance absolue $C_j(t)$ mesurée par chaque électrode avec précision est mathématiquement proportionnelle à l'intégrale de la densité de charge sur la surface *Aj* de cette électrode, la figure 3a illustre de telles électrodes :

$$C_j(t) = \int (\partial\Phi/\partial n)(t)\ ds, \quad j = 1, 2, ..., N$$

Où N nombre d'électrode réelles, *n* le vecteur normal à la surface mesurant, $\Phi$ le potentiel électrique à l'instant t, *ds* l'élément infinitésimal de la surface. La dérivée normale $(\partial\Phi/\partial n)$ est la densité de charge surfacique.

Le potentiel électrique vérifie l'équation électrostatique :

- $\Delta\Phi = 0$ dans $\Omega$, où $\Omega$ est le volume 3D représentent le demi volume en trois dimension où se trouve la zone de sensibilité,
- $\partial\Omega = \Gamma(t)\ U$ dalle, $\Gamma(t)$ est une fonction de la surface de l'objet en mouvement devant l'appareil, où la dalle est l'ensemble de la surface active sur laquelle le potentiel d'excitation est appliqué.

- Les conditions de radiations à l'infinie,

  $\Phi = 0$ sur $\Gamma(t)$,

  $\Phi = 1$ sur la surface de la dalle.

Sur la figure 2, on voit une représentation de la fonction r(t) en forme d'une courbe évoluant au dessus d'une surface de détection. Cette courbe représente par exemple le déplacement d'un doigt au dessus d'un écran. Le potentiel électrique dépend de la forme et de la position de l'objet.

La surface totale capacitive est partitionnée en N électrodes. Les deux valeurs 0 et 1 Volts sont données à titre d'exemple. La valeur 0 est le potentiel de la terre, et 1 la valeur référence du potentiel d'excitation. Il s'agit de la valeur d'excitation flottante dans le cas d'une mesure par la technique de pont capacitif flottant telle que décrite dans le document WO2011/015795 dont le contenu est inséré ici par référence.

En parallèle à des mesures {Cj(t)} effectuées par un vrai appareil ayant des électrodes réelles non-régulières en forme, on considère également la réponse par un appareil « virtuel », qui subit le même potentiel électrique et le même champ électrique que l'appareil réel. La différence est que cet appareil « virtuel » possède un découpage des électrodes plus régulier donc une réponse capacitive sous forme d'une image qui reflète fidèlement la fonction de densité de probabilité qu'un objet se présente à un endroit. La capacitance absolue virtuelle Cv_j(t) mesurée par chaque électrode est mathématiquement proportionnel à l'intégrale de la densité de charge sur la surface *Bj* qui est une surface idéale de l'électrode, c'est-à-dire une surface n'ayant pas de piste de connexion, la figure 3b illustrant de telles électrodes :

$$Cv_j(t) = \int (\partial\Phi/\partial n)(t)\, ds, \qquad j = 1, 2, \ldots, Nv$$

Où Nv est le nombre d'électrodes virtuelles, $\Phi$ le même potentiel électrique à l'instant t, *ds* est l'élément d'infinitésimal de la surface.

Le nombre des électrodes virtuelles peut être identique ou supérieur au nombre des électrodes réelles. Afin d'augmenter la résolution de détection des deux ou plusieurs objets très proches l'un par rapport à l'autre.

Pour déterminer le modèle de passage du réel vers le virtuel (=électrodes idéales), il s'agit de calculer à partir de moyens numériques comprise dans une unité de traitement {Cv_j(t)} à partir de {Cj(t)}. La fonction de passage de l'une vers l'autre peut être déterminée de plusieurs manières.

1. D'abord on choisit un ensemble de positions des objets sur le volume de détections. Cet ensemble doit être représentatif pour couvrir suffisamment tous les cas d'utilisation envisageables de l'appareil.

2. Sur cet ensemble de positions, on calcule le potentiel électrique par exemple par des simulations numériques au moyen d'un calculateur. Ce qui nous fournit un ensemble de potentiels électriques qui recouvre les cas d'utilisation de l'appareil.

3. Sur cet ensemble on calcule respectivement des réponses avec l'appareil réel {Cj(t)} et l'appareil virtuel (Cv_j(t)) en intégrant la même densité de charge ($\partial\Phi/\partial n$) sur les surfaces respectives *Aj et Bj.*

4. Une méthode de régression statistique ou d'identification de modèle permet de déterminer le modèle permettant de calculer de façon approximative {Cv_j(t)} en fonction de {Cj(t)}.

Les étapes 2 et 3 ci-dessus peuvent être réalisées par simulation numérique ou par un procédé expérimental : un appareil avec des électrodes non-régulières et un autre appareil avec des électrodes idéalisées régulières, mesurant les mêmes positions de l'objet dans l'ensemble fixé dans l'étape 1. Ces deux appareils peuvent mesurer séquentiellement la même séquence, ou bien synchronisé mécaniquement afin de minimiser les erreurs de mesures.

A l'étape 4, on peut utiliser une méthode de régression telle que la méthode des « moindres carrées partiels » (PLS). La méthode PLS permet de relier la réponse des électrodes réelles et des électrodes virtuelles avec un modèle linéaire, à travers une 3e variable qui s'appelle variable de latente. La méthode PLS est dite bilinéaire. D'autres techniques d'identification de modèle comme les méthodes de moindres carrées avec régularisation de Ridge, ou régression Lasso, etc... peuvent être utilisées à la place de la méthode PLS.

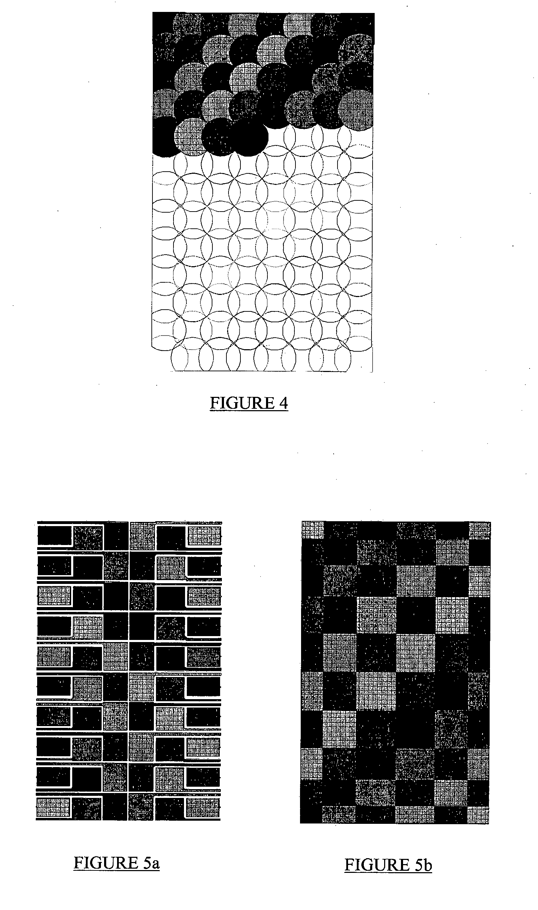

Sur la figure 3a on voit une représentation des électrodes réelles. Elles possèdent toutes une piste d'accès vers l'une des deux parois latérales. Les surfaces de ces électrodes ne sont pas régulières. Sur la figure 3b, les électrodes virtuelles présentent une partition de la surface de mesure par des rectangles réguliers, on peut envisager que les surfaces des électrodes virtuelles soient d'autres formes, par exemple des disques de même surface et qui se chevauchent. Une telle réalisation est illustrée sur la Figure 4. Le fait que la forme de chaque électrode soit un disque permet d'avoir une réponse plus isotropique dans le plan parallèle à la surface de détection. Il est plus pratique d'implémenter la réponse de telles électrodes virtuelles se chevauchant (par simulation) que de façon expérimentale.

De même que sur la forme, la répartition des électrodes virtuelles peut être différente de celle des électrodes réelles. On peut envisager une plus grande concentration sur les bords afin de mieux capter la forme de la fonction de densité de probabilité sur les bords de la surface de détection, comme on peut le voir sur la figure 5b ; la figure 5a étant une représentation des électrodes réelles. Donc la forme et la répartition des électrodes virtuelles peuvent être différentes de celles des électrodes réelles. On peut aussi envisager d'avoir une grille plus dense là où une plus grande précision de détection est exigée, par exemple au milieu de la surface de détection.

Selon un autre mode de réalisation, au lieu d'utiliser la réponse des électrodes virtuelles $Cv_j(t)$ comme une réponse de sortie désirée, un ensemble d'images - qui n'a pas forcément de signification physique - peut être utilisé comme une sortie désirée. Par exemple l'image peut être un échantillonnage de la fonction de densité de probabilité issue directement de la position exacte de l'objet - par exemple une Gaussienne 2D centrée, la position horizontale sur l'objet, la largeur de la gaussienne dépendant de la position verticale de l'objet.

$$Gj(t) = A(z0) * exp[ - ((xj - xo)^2 + (yj - yo)^2) / \sigma(zo)^2 ],$$

où : où : $(xj,yj)$ sont des coordonnées d'une grille régulière sur une surface de détection comprenant les électrodes ; $(xo(t),yo(t),zo(t))$ sont des coordonnées 3D de l'extrémité de l'objet la plus proche de la surface de détection ; $A(zo)$ et $\sigma(zo)$ sont deux fonctions prédéterminées dépendant de la distance $z0$ de façon monotone, $A(z)$ étant décroissante et $\sigma(zo)$ croissante.

Selon l'invention, le modèle permettant d'obtenir les matrices de multiplication et les vecteurs de translation d'une fonction affine, peut être obtenu par une transformation qui convertit les mesures $C_j(t)$ vers les sorties $Cv_j(t)\}$, ou alternativement vers les sorties $Gj(t)$

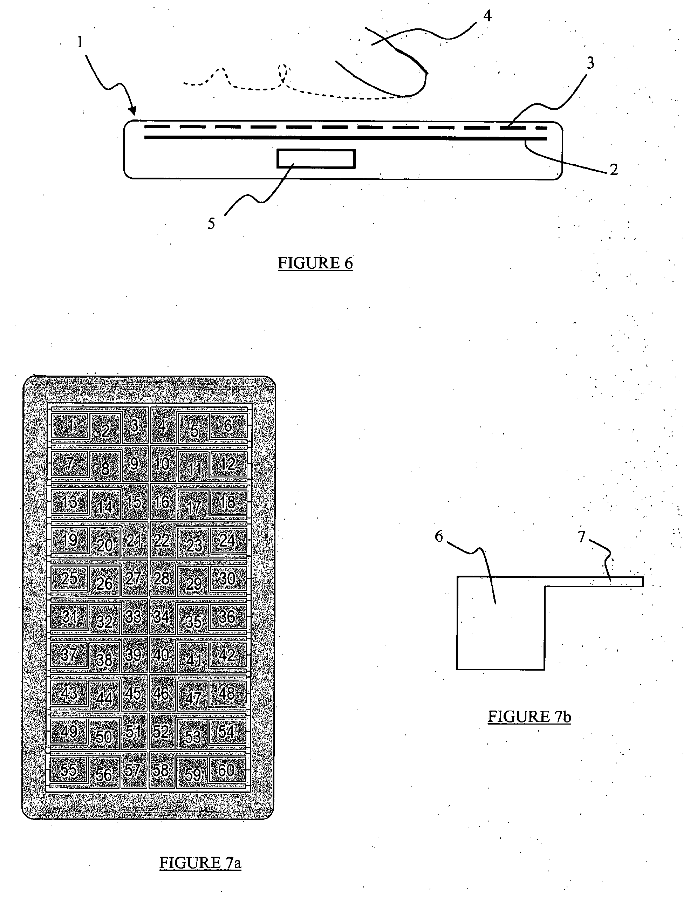

L'invention comporte également une phase de fonctionnement au cours de laquelle un utilisateur utilise un appareil doté d'un écran et d'un dispositif de détection. Un tel appareil peut être un téléphone intelligent de type « smartphone » représenté en 1 sur la figure 6. Cet appareil 1 comporte un écran d'affichage 2 et un dispositif de détection capacitive. Ce dernier comprend un circuit électronique (non représenté) à pont flottant tel que décrit dans le document WO2011/015795. Un tel circuit électronique comprend notamment des électrodes capacitives de mesures et des électrodes de garde pour limiter l'influence de capacités parasites sources de perturbations. En d'autres termes, l'appareil peut comporter un plan conducteur utilisé comme garde active contre des fuites capacitives, ce plan conducteur peut être de technologie à pont flottant comme décrit dans le document FR 2 844 349 de Rozière ou d'autres technologies. L'appareil peut aussi ne contenir aucune garde. De façon générale, une garde est un plan conducteur sensiblement au même potentiel que les électrodes de mesure.

Sur la figure 6, une matrice d'électrodes capacitives de mesure 3 est disposée au dessus d'un écran d'affichage 2. Les électrodes capacitives 3 sont en oxyde d'indium dopé à l'étain (ITO).

Sur la figure 7a est représentée la matrice des électrodes capacitives 3 qui sont numérotées de 1 à 60. Chaque électrode est prévue pour être connectée à un circuit électronique (non représenté) depuis la périphérie latérale gauche ou droite de l'appareil. Comme on le voit sur la figure 7b, chaque électrode capacitive comporte une partie utile 6, typiquement en forme rectangulaire, et une piste de connexion 7 permettant de connecter la partie utile 6 à la périphérie interne de l'appareil 1. Les pistes de connexion descendent ensuite à l'intérieur de l'appareil jusqu'au circuit électronique. L'invention permet de limiter l'influence des pistes de connexion 7 de façon à ce que la capacité détectée soit équivalente à une capacité qui serait détectée par une électrode idéale ne comportant que la partie utile 6.

Sur la figure 6 est représentée une unité de traitement 5 pilotant l'ensemble des composants de l'appareil 1. Cette unité de traitement peut être un microprocesseur ou un microcontrôleur équipé de moyens matériels et logiciels conventionnels pour piloter notamment l'écran d'affichage et la matrice d'électrodes 3. Cette matrice d'électrodes est conçue pour détecter les gestes d'un doigt 4 dans un volume au dessus de l'écran d'affichage 2. L'utilisateur déplace son doigt 4 qui est détecté par l'unité de traitement 5 au moyen de la matrice d'électrodes 3. L'unité de traitement analyse ces gestes de façon à alimenter une application logicielle active au sein de l'appareil, notamment via l'écran d'affichage 2.

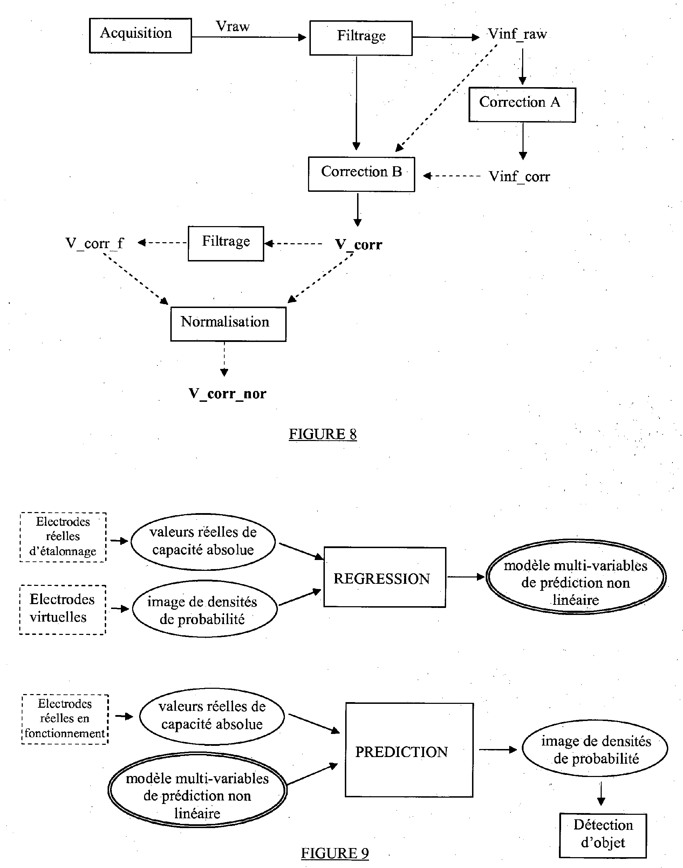

Pour que la détection du doigt 4 se fasse de manière efficace sans perturbations qui seraient dues aux pistes de connexion, l'unité de traitement 5 est configurée selon l'invention pour réaliser les opérations telles que décrites sur la figure 8.

L'objectif est de corriger les valeurs de capacité acquises en mode de fonctionnement temps réel par les électrodes en utilisant les paramètres virtuels obtenus lors de l'étalonnage.

On va maintenant décrire les différentes opérations mises en oeuvre par le procédé selon l'invention en mode de fonctionnement comme représentées sur la figure 8.

**Acquisition**

Il s'agit de la mesure de la capacitance absolue de la matrice d'électrodes. On acquiert N tensions $Vraw_i = k / C_i$, avec $C_i$ la capacitance absolue mesurée sur l'électrode réelle i, N le nombre d'électrodes, et k un gain choisi tel

que $max(Vraw_i)$ = max Volt, un seuil choisi préalablement, par exemple Vmax = 5 V.

**Filtrage**

Il s'agit d'une opération de filtrage, nommée filtre max, telle que décrite dans le document FR1059203 (n° d'enregistrement). Deux exemples d'un tel filtrage sont notamment :

$$Vinf\_raw(t0) = max \{ Vraw(t) : t \in (-\infty, t0) \}$$

ou

$$Vinf\_raw(t0) = max \{ Vraw(t) : t \in (t0 - windowsize, t0) \},$$

avec *windowsize* la période temporelle de la fenêtre de l'auto-calibration - c'est-à-dire période temporelle dans laquelle toute perturbation inchangée sera considérée comme causée par un objet de non-intérêt, t0 l'instant de la mesure.
Alternativement, le filtre max peut être remplacé par une calibration usine, qui fournit les valeurs de Vinf_raw, mesurées à l'usine est stockées dans une zone mémoire.

Correction A

On corrige les capacitances de fuite naturelle des électrodes réelles.
Le principe de la correction est d'appliquer trois transformations successives:

- une fonction non-linéaire X1 = F1(Vinf_raw) sur les N tensions individuellement, puis
- on applique une transformation linéaire sur X1 à travers une matrice [M1] et un vecteur de translation dit vecteur d'offset Y01:

    Y1 = [M1].X+Y01, Y01 pouvant être nul ; la matrice M1 et le vecteur Y01 étant obtenu à partir du modèle de transformation déterminé lors de la phase d'étalonnage.
    Cette transformation combine les valeurs réelles entre elles à travers de la matrice M1, puis

- on applique la transformation non-linéaire inverse Vinf_corr = F1$^{-1}$(Y1).

Plusieurs fonctions F1 peuvent être utilisées, parmi lesquelles:

- F11(V) := 1/V
- F12(V) := 1 / (V/Vmax + $\beta$), avec $\beta$>0, un nombre introduit pour éviter la singularité lorsque V $\approx$ 0, on peut choisir à titre d'exemple $\beta$ = 0.1, 0.2 ou 0.3.
- F13(V) : = V/Vmax.

**Correction B**

On corrige ici les capacitances absolues en présence de l'objet d'intérêt à proximité des électrodes réelles.
On reprend le principe de la correction précédente mais avec des vecteurs d'entrée différents. On applique également trois transformations successives:

- une fonction non-linéaire X2 = F2(Vraw, Vinf_raw) sur les N tensions individuellement, puis
- on applique une transformation linéaire sur X2 à travers une matrice [M2] et un vecteur de translation dit vecteur d'offset Y02:

    Y2 = [M2].X+YO2, Y02 pouvant être nul ; la matrice M2 et le vecteur Y02 étant obtenu à partir du modèle de transformation déterminé lors de la phase d'étalonnage.

- on applique la transformation non-linéaire inverse V_corr = F2$^{-1}$(Y2, Vinf_corr). La fonction F2$^{-1}$ est l'inverse de la fonction non-linéaire F2 lorsque celle-ci est considérée comme fonction de son premier paramètre F2(Vraw) ; le deuxième paramètre Vinf_raw étant considéré comme fixé.

Plusieurs fonctions F2 peuvent être utilisées, parmi lesquelles:

- F21(V) := 1/V
- F22(V) : = V/Vinf*
- F23(V): = 1 - V/Vinf*
- F24(V) : = 1 / (V/Vmax + β)
- F25(V) : = V/Vmax.

Pour les calculs des fonctions F22 et F23 et leurs inverses, *Vinf\* = Vinf_raw* pour la transformation non-linéaire directe, ou *Vinf_corr* pour la transformation non-linéaire inverse.

Avec les fonctions F21, F24 et F25, il est possible de réaliser directement la correction B et obtenir un vecteur V_corr de valeurs réelles corrigées.

Les matrices [*M1*] [*M2*] et l'offset *Y1 et Y2* sont estimées par une méthode de régression numérique tel que par exemple la méthode PLS (« partial least-square ») à partir de la simulation de l'appareil ayant des électrodes réelles et un deuxième appareil avec des électrodes virtuelles avec un doigt positionné sur plusieurs endroits sur un volume au-dessus de l'appareil pour la régression pendant la correction B (matrice M2 et vecteur Y2). En d'autres termes, M1,Y1 et M2,Y2 sont différents et sont obtenus par deux régressions PLS :

- (M1, Y1) sur l'inverse des fuites naturelles des capacitances (1/Cinf), Cinf étant la fuite capacitive naturelle (en absence de l'objet d'intérêt) de l'appareil.
- - (M2, Y2) sur les capacitances absolues avec l'objet qui se positionne dans le volume de détection.

**Normalization**

On utilise un filtre max pour calculer :

$$V\_corr\_f(t0) = \max \{ Vcorr (t) : t \in (-\infty, t0) \}$$

ou

$$V\_corr\_f(t0) = \max \{ Vcorr (t) : t \in (t0 - \mathit{windowsize}, t0) \},$$

avec *windowsize* la période temporelle de la fenêtre de l'auto-calibration - c'est-à-dire période temporelle dans laquelle toute perturbation inchangée sera considérée comme causée par un objet de non-intérêt, t0 l'instant de la mesure.

Dans l'exemple décrit ci-dessus, les transformations non-linéaires A et B sont décomposées comme : (1) une transformation non-linéaire indépendante des entrées, suivie par (2) une transformation affine, suivie par (3) une autre transformation non-linéaire indépendante. Une autre réalisation possible des transformations A et B est le modèle *des réseaux de neurones artificiels.* Les entrées V_raw et Vinf_raw et les sorties V_corr et Vinf_corr seront utilisées pour l'apprentissage du réseau.

Alternativement, le filtre max peut être remplacé par une calibration usine, qui fournit les valeurs de V_corr_f, mesurées à l'usine est stockées dans une zone de mémoire.

Ensuite une image dite de normalisation est faite pour fournir une image finale. Cette normalisation dépend de V_corr et V_corr_f. Par exemple l'image dont les valeurs sont le rapport des deux images Vorr et V_corr_f:

$$V\_corr\_nor = V\_corr/V\_corr\_f$$

L'image normalisée ainsi calculée donne une fonction de densité de probabilité de présence de l'objet d'intérêt. Elle est utilisée par l'unité de traitement afin de détecter la présence et la position de l'objet d'intérêt (le doigt) par exemple en calculant l'espérance de la distribution par une méthode de barycentre, ou le MODE (la valeur prise le plus souvent) de la fonction de densité de probabilité. Une interpolation de type « spline » peut être utilisée pour une résolution sous pixel des MODE (MODE : la valeur d'une variable aléatoire qui a le plus de chance de se réaliser, il s'agit de l'endroit du maximum de la fonction de densité de probabilité).

D'une façon générale, comme on le voit sur la figure 9, l'invention peut comporter une phase d'étalonnage au cours de laquelle on détermine un modèle multi-variables de prédiction non linéaire en réalisant une régression non linéaire à partir :

- de valeurs réelles de capacité absolue obtenues pour une pluralité de positions d'objet par rapport au plan d'électrodes, et
- d'une image de densités de probabilité obtenue pour une pluralité de positions d'objet par rapport à un plan d'électrodes idéalisées.

L'invention comporte ensuite une phase de fonctionnement (au quotidien) au cours de laquelle, à chaque détection, on utilise le modèle obtenu à la phase d'étalonnage. Pour ce faire, après avoir réalisé des mesures sur les électrodes, on réalise une prédiction en appliquant ce modèle multi-variables de prédiction non linéaire sur les valeurs réelles de capacité absolue de façon à obtenir une image de densités de probabilité, ces densités de probabilité étant considérées comme des valeurs de capacité absolue, corrigées que l'on utilise pour la détection de l'objet.

De préférence, l'étalonnage est faite une fois pour toute, le modèle étant sauvegardé en mémoire de chaque appareil.

Bien sûr, l'invention n'est pas limitée aux exemples qui viennent d'être décrits et de nombreux aménagements peuvent être apportés à ces exemples sans sortir du cadre de l'invention.

**Revendications**

1. Procédé de mesure capacitive absolue d'un objet par rapport à au moins deux électrodes indépendantes intégrées dans un dispositif d'interface homme-machine pour la détection dudit objet, **caractérisé en ce qu'**il comprend les étapes suivantes :

   a) pour chaque électrode, on mesure une valeur de capacité absolue entre l'électrode et l'objet,
   a') on réalise une prédiction en appliquant un modèle multi-variables de prédiction non linéaire sur les valeurs réelles de capacité absolue de façon à obtenir une image de densités de probabilité, ces densités de probabilité étant considérées comme des valeurs de capacité absolue corrigées que l'on utilise pour la détection dudit objet.

2. Procédé selon la revendication 1, **caractérisé en ce que** le modèle multi-variables de prédiction non linéaire est obtenu par régression non linéaire à partir ;

   - de valeurs réelles de capacité absolue obtenues pour une pluralité de positions d'objet par rapport auxdites au moins deux électrodes, et
   - d'une image de densités de probabilité obtenue pour une pluralité de positions d'objet par rapport à des électrodes idéalisées.

3. Procédé selon la revendication 1 ou 2, **caractérisé en ce qu'**à l'étape a) on constitue un vecteur $V_{raw}$ à partir des valeurs de capacité absolue mesurées et la prédiction à l'étape a') comprend les étapes suivantes :

   b) application d'une première transformation non-linéaire F2 sur au moins le vecteur $V_{raw}$ de façon à obtenir un vecteur X2,
   c) application d'une transformation affine de façon à obtenir un vecteur Y2 en multipliant le vecteur X2 par une matrice M2 et en ajoutant un vecteur de translation Y02 ; la matrice M2 étant une matrice de transfert entre un vecteur de valeurs réelles de capacité absolue obtenues sur des électrodes de surface non-régulière en présence d'objet, et un vecteur de valeurs virtuelles obtenues pour des électrodes idéalisées en présence d'objet,
   d) application sur au moins le vecteur Y2 d'une seconde transformation non-linéaire qui est inverse de la première transformation non-linéaire F2 de façon à obtenir un vecteur de correction V_corr, et
   e) utilisation du vecteur de correction V_corr comme valeurs de capacité absolue pour la détection dudit objet.

4. Procédé selon la revendication 3, **caractérisé en ce que** la fonction F2 est telle que $F2(V_{raw}) = 1/V_{raw}$

5. Procédé selon la revendication 3, **caractérisé en ce que** la fonction F2 est telle que $F2(V_{raw}) = 1/(V_{raw}/Vmax + \beta)$ , Vmax étant une tension maximum prédéterminée, et $\beta$ un nombre positif.

6. Procédé selon la revendication 3, **caractérisé en ce que** la fonction F2 est telle que $F2(V_{raw}) - V_{raw}/Vmax$ , Vmax étant une tension maximum prédéterminée.

7. Procédé selon la revendication 3, **caractérisé en ce qu'**après l'étape a), on réalise les étapes suivantes :

- filtrage des valeurs du vecteur $V_{raw}$ de façon à obtenir un vecteur $V_{inf\_raw}$
- application d'une transformation non-linéaire F1 sur le vecteur $V_{inf\_raw}$ de façon à obtenir un vecteur X1,
- application d'une transformation affine de façon à obtenir un vecteur Y1 en multipliant le vecteur X1 par une matrice M1 et en ajoutant un vecteur de translation Y01 ; la matrice M1 étant une matrice de transfert entre un vecteur de valeurs réelles de capacité absolue obtenues sur des électrodes de surface non-régulière en absence d'objet de détection, et un vecteur de valeurs virtuelles en absence d'objet de détection, et
- application sur le vecteur Y1 d'une transformation non-linéaire qui est inverse de la transformation non-linéaire F1 de façon à obtenir un vecteur de correction Vinf_corr,
- puis réalisation des étapes b) à e), dans lesquelles, à l'étape b) on applique la transformation non-linéaire F2 sur les vecteurs $V_{raw}$ et $V_{inf\_raw}$ de façon à obtenir un vecteur X2 fonction de $V_{raw}$ et $V_{inf\_raw}$ ; et à l'étape d) on applique sur les vecteurs Y2 et Vinf_corr une seconde transformation non-linéaire qui est inverse de la première transformation non-linéaire F2 de façon à obtenir un vecteur de correction V_corr qui est fonction de Y2 et Vinf_corr.

8. Procédé selon la revendication 7, **caractérisé en ce que** la fonction F1 est telle que $F1(V_{raw}) = 1/V_{raw}$.

9. Procédé selon la revendication 7, **caractérisé en ce que** la fonction F1 est telle que $F1(V_{raw}) = 1/(V_{raw}/Vmax + \beta)$, Vmax étant une tension maximum prédéterminée, et p un nombre positif.

10. Procédé selon la revendication 7, **caractérisé en ce que** la fonction F1 est telle que $F1(V_{raw}) = V_{raw}/Vmax$, Vmax étant une tension maximum prédéterminée.

11. Procédé selon l'une quelconque des revendications 7 à 10, **caractérisé en ce que** la fonction F2 est telle que $F2(V_{raw}\ V_{inf*}) = V_{raw}/V_{inf*}$ ; $V_{inf*}$ étant égal à $V_{inf\_raw}$ lors de la transformation non linéaire à l'étape b), et égal à $V_{inf\_corr}$ lors de la transformation non linéaire inverse à l'étape d).

12. Procédé selon l'une quelconque des revendications 7 à 10, **caractérisé en ce que** la fonction F2 est telle que $F2(V_{raw}, V_{inf*}) = 1-(V_{raw}/V_{inf*})$ ; $V_{inf*}$ étant égal à $V_{inf\_raw}$ lors de la transformation non linéaire à l'étape b), et égal à $Vinf\_corr$ lors de la transformation non linéaire inverse à l'étape d).

13. Procédé selon l'une quelconque des revendications 3 à 12, **caractérisé en ce qu'**il comprend en outre au cours de l'étape e) une étape de normalisation du vecteur de correction V_corr au cours de laquelle on réalise les étapes suivantes :

- filtrage du vecteur de correction V_corr pour obtenir un vecteur filtré V_corr_f, et
- normalisation du vecteur de correction avec le vecteur filtré filtré V_corr_f de façon à obtenir un vecteur normalisé V_corr_nor.

14. Procédé selon l'une quelconque des revendications 7 à 13, **caractérisé en ce que** le filtrage est obtenu selon la formule suivante :

$V(t0) = \max \{ V(t) : t \in (-\infty, t0) \}$ ; t0 étant l'instant de la mesure, V(t) étant le vecteur sur lequel s'applique le filtrage, t étant l'indice temporel.

15. Procédé selon l'une quelconque des revendications 7 à 13, **caractérisé en ce que** le filtrage est obtenu selon la formule suivante :

$V(t0) = \max \{ V(t) : t \in (t0 - windowsize, t0) \}$, avec *windowsize* une période temporelle de la fenêtre de l'auto-calibration, t0 étant l'instant de la mesure, V(t) étant le vecteur sur lequel s'applique le filtrage, t étant l'indice temporel.

16. Procédé selon l'une quelconque des revendications 7 à 13, **caractérisé en ce que** le filtrage est obtenu en remplaçant le vecteur sur lequel s'applique le filtrage par un vecteur prédéterminé.

**17.** Procédé selon l'une quelconque des revendications 3 à 16, **caractérisé en ce que** la matrice M est obtenue par la méthode des moindres carrés partiels, le vecteur de valeurs virtuelles étant un vecteur de valeurs obtenues pour des électrodes idéalisées.

**18.** Procédé selon l'une quelconque, des revendications 3 à 16, **caractérisé en ce que** la matrice M est obtenue à partir d'un échantillonnage d'une fonction de densité de probabilité issue d'une multitude de positions exactes d'objet par rapport aux électrodes, le vecteur de valeurs virtuelles étant un vecteur dont les valeurs sont des probabilités de présence.

**19.** Procédé selon la revendication 18, **caractérisé en ce que** la fonction de densité de probabilité est une gaussienne 2D centrée sur chaque position horizontale d'objet, dont la largeur dépend de la position vertical de l'objet, cette gaussienne étant définie par la formule suivante :

$$Gj(t) = A(z0) * exp[ - ((xj - xo)^2 + (yj - yo)^2) / \sigma(zo)^2 ],$$

où : (xj,yj) sont des coordonnées d'une grille régulière sur une surface de détection comprenant les électrodes ; (xo(t),yo(t),zo(t)) sont des coordonnées 3D de l'extrémité de l'objet la plus proche de la surface de détection ; A(zo) et $\sigma$(zo) sont deux fonctions prédéterminées dépendant de la distance z0 de façon monotone, A(z) étant décroissante et $\sigma$(zo) croissante.

**20.** Procédé selon l'une quelconque des revendications précédentes, **caractérisé en ce que** les électrodes présentent des surfaces non-régulières.

**21.** Appareil électronique comprenant :

- deux électrodes indépendantes intégrées dans un dispositif d'interface homme-machine
- une unité de traitement pour détecter la position d'un objet par mesure de la capacité absolue dudit objet par rapport aux électrodes, **caractérisé en ce que** l'unité de traitement est configurée pour réaliser au moins les étapes suivantes :

a) pour chaque électrode, on mesure une valeur de capacité absolue entre l'électrode et l'objet,
a') on réalise une prédiction en appliquant un modèle multi-variables de prédiction non linéaire sur les valeurs réelles de capacité absolue de façon à obtenir une image de densités de probabilité, ces densités de probabilité étant considérées comme des valeurs réelles corrigées que l'on utilise pour la détection dudit objet.

**22.** Appareil selon la revendication 21, **caractérisé en ce que** le modèle multi-variables de prédiction non linéaire est obtenu par régression non linéaire à partir :

- de valeurs réelles de capacité absolue obtenues pour une pluralité de positions d'objet par rapport auxdites au moins deux électrodes, et
- d'une image de densités de probabilité obtenue pour une pluralité de positions d'objet par rapport à des électrodes idéalisées.

**23.** Appareil selon la revendication 21 ou 22, **caractérisé en ce que** l'unité de traitement est également configurée pour réaliser les étapes suivantes :

- à l'étape a) on constitue un vecteur V$_{raw}$ à partir des valeurs de capacité absolue mesurées et la prédiction à l'étape a') comprend les étapes suivantes :

b) application d'une première transformation non-linéaire F2 sur a moins le vecteur V$_{raw}$ de façon à obtenir un vecteur X2 ,
c) application d'une transformation affine de façon à obtenir un vecteur Y2 en multipliant le vecteur X2 par une matrice M2 et en ajoutant un vecteur de translation Y02 ; la matrice M2 étant une matrice de transfert entre un vecteur de valeurs réelles de capacité absolue obtenues sur des électrodes de surface non-régulière en présence d'objet, et un vecteur de valeurs virtuelles en présence d'objet,

d) application sur au moins le vecteur Y2 d'une seconde transformation non-linéaire qui est inverse de la première transformation non-linéaire F2 de façon à obtenir un vecteur de correction V_corr, et

e) utilisation du vecteur de correction V_corr comme valeurs de capacité absolue pour la détection dudit objet.

**24.** Appareil selon l'une quelconque des revendications 21 à 23, **caractérisé en ce que** les électrodes sont conçues à partir de l'oxyde d'indium dopé à l'étain.

**25.** Procédé selon l'une quelconque des revendications 21 à 24, **caractérisé en ce que** les électrodes présentent des surfaces non-régulières.


**Patentansprüche**

**1.** Verfahren zur absoluten kapazitiven Messung eines Objektes in Bezug auf wenigstens zwei unabhängige Elektroden, die in eine Mensch-Maschine-Schnittstellenvorrichtung zur Erfassung des Objektes integriert sind, **dadurch gekennzeichnet, dass** es die folgenden Schritte umfasst:

a) für jede Elektrode wird ein absoluter Kapazitätswert zwischen der Elektrode und dem Objekt gemessen,

a') durch Anwendung eines multivariaten Modells zur nichtlinearen Prädiktion auf die reellen absoluten Kapazitätswerte wird eine Vorhersage vollzogen, um ein Bild von Wahrscheinlichkeitsdichten zu erhalten, wobei diese Wahrscheinlichkeitsdichten als korrigierte absolute Kapazitätswerte betrachtet werden, die für die Erfassung des Objektes verwendet werden.

**2.** Verfahren nach Anspruch 1, **dadurch gekennzeichnet, dass** das multivariate Modell zur nichtlinearen Prädiktion erhalten wird durch nichtlineare Regression aus:

- reellen absoluten Kapazitätswerten, die für eine Vielzahl von Objektpositionen in Bezug auf die wenigstens zwei Elektroden erhalten werden, und
- einem Wahrscheinlichkeitsdichtebild, das für eine Vielzahl von Objektpositionen in Bezug auf idealisierte Elektroden erhalten wird.

**3.** Verfahren nach Anspruch 1 oder 2, **dadurch gekennzeichnet, dass** bei Schritt a) ein Vektor $V_{raw}$ anhand der gemessenen absoluten Kapazitätswerte gebildet wird und die Vorhersage bei Schritt a') die folgenden Schritte umfasst:

b) Anwendung einer ersten nichtlinearen Transformation F2 auf wenigstens den Vektor $V_{raw}$, um einen Vektor X2 zu erhalten,

c) Anwendung einer affinen Transformation, um einen Vektor Y2 zu erhalten, indem der Vektor X2 mit einer Matrix M2 multipliziert wird und ein Translationsvektor Y02 hinzugefügt wird; wobei die Matrix M2 eine Transfermatrix zwischen einem Vektor reeller absoluter Kapazitätswerte, die an Elektroden mit unregelmäßiger Oberfläche in Gegenwart eines Objektes erhalten werden, und einem Vektor virtueller Werte, die für idealisierte Elektroden in Gegenwart eines Objektes erhalten werden, ist,

d) Anwendung, auf wenigstens den Vektor Y2, einer zweiten nichtlinearen Transformation, die zu der ersten nichtlinearen Transformation F2 invers ist, um einen Korrekturvektor V_corr zu erhalten, und

e) Verwendung des Korrekturvektors V_corr als absolute Kapazitätswerte für die Erfassung des Objektes.

**4.** Verfahren nach Anspruch 3, **dadurch gekennzeichnet, dass** die Funktion F2 derart ist, dass $F2(V_{raw}) = 1/V_{raw}$.

**5.** Verfahren nach Anspruch 3, **dadurch gekennzeichnet, dass** die Funktion F2 derart ist, dass $F2(V_{raw}) = 1/(V_{raw}/Vmax + \beta)$, wobei Vmax eine vorbestimmte Maximalspannung ist und $\beta$ eine positive Zahl ist.

**6.** Verfahren nach Anspruch 3, **dadurch gekennzeichnet, dass** die Funktion F2 derart ist, dass $F2(V_{raw}) = V_{raw}/Vmax$, wobei Vmax eine vorbestimmte Maximalspannung ist.

**7.** Verfahren nach Anspruch 3, **dadurch gekennzeichnet, dass** nach Schritt a) die folgenden Schritte durchgeführt werden:

- Filterung der Werte des Vektors $V_{raw}$, um einen Vektor $V_{inf\_raw}$ zu erhalten,
- Anwendung einer nichtlinearen Transformation F1 auf den Vektor $V_{inf\_raw}$. um einen Vektor X1 zu erhalten,
- Anwendung einer affinen Transformation, um einen Vektor Y1 zu erhalten, indem der Vektor X1 mit einer Matrix M1 multipliziert wird und ein Translationsvektor Y01 hinzugefügt wird; wobei die Matrix M1 eine Transfermatrix zwischen einem Vektor reeller absoluter Kapazitätswerte, die an Elektroden mit unregelmäßiger Oberfläche in Abwesenheit eines Erfassungsobjektes erhalten werden, und einem Vektor virtueller Werte in Abwesenheit eines Erfassungsobjektes ist, und
- Anwendung, auf den Vektor Y1, einer nichtlinearen Transformation, die zu der nichtlinearen Transformation F1 invers ist, um einen Korrekturvektor Vinf_corr zu erhalten,
- anschließend Durchführung der Schritte b) bis e), bei denen, bei Schritt b), die nichtlineare Transformation F2 auf die Vektoren $V_{raw}$ und $V_{inf\_raw}$ angewandt wird, um einen Vektor X2, welcher von $V_{raw}$ und $V_{inf\_raw}$ abhängig ist, zu erhalten; und bei Schritt d) auf die Vektoren Y2 und Vinf_corr eine zweite nichtlineare Transformation, die zu der ersten nichtlinearen Transformation F2 invers ist, angewandt wird, um einen Korrekturvektor V_corr, welcher von Y2 und Vinf_corr abhängig ist, zu erhalten.

8. Verfahren nach Anspruch 7, **dadurch gekennzeichnet, dass** die Funktion F1 derart ist, dass $F1(V_{raw}) = 1/V_{raw}$.

9. Verfahren nach Anspruch 7, **dadurch gekennzeichnet, dass** die Funktion F1 derart ist, dass $F1(_{Vraw}) = 1/(V_{raw}/Vmax + \beta)$, wobei Vmax eine vorbestimmte Maximalspannung ist und $\beta$ eine positive Zahl ist.

10. Verfahren nach Anspruch 7, **dadurch gekennzeichnet, dass** die Funktion F1 derart ist, dass $F1(V_{raw}) = V_{raw}/Vmax$, wobei Vmax eine vorbestimmte Maximalspannung ist.

11. Verfahren nach einem der Ansprüche 7 bis 10, **dadurch gekennzeichnet, dass** die Funktion F2 derart ist, dass $F2(V_{raw}, V_{inf}^*) = V_{raw}/V_{inf}^*$; wobei $V_{inf}^*$ bei der nichtlinearen Transformation bei Schritt b) gleich $V_{inf\_raw}$ ist und bei der inversen nichtlinearen Transformation bei Schritt d) gleich Vinf_corr ist.

12. Verfahren nach einem der Ansprüche 7 bis 10, **dadurch gekennzeichnet, dass** die Funktion F2 derart ist, dass $F2(V_{raw}, V_{inf^*}) = 1 - (V_{raw}/V_{inf^*})$; wobei $V_{inf^*}$ bei der nichtlinearen Transformation bei Schritt b) gleich $V_{inf\_raw}$ ist und bei der inversen nichtlinearen Transformation bei Schritt d) gleich Vinf_corr ist.

13. Verfahren nach einem der Ansprüche 3 bis 12, **dadurch gekennzeichnet, dass** es ferner während des Schrittes e) einen Schritt zur Normierung des Korrekturvektors V_corr umfasst, im Laufe dessen die folgenden Schritte durchgeführt werden:

    - Filterung des Korrekturvektors V_corr, um einen gefilterten Vektor V_corr_f zu erhalten,
    - Normierung des Korrekturvektors mit dem gefilterten Vektor V_corr_f, um einen normierten Vektor V_corr_nor zu erhalten.

14. Verfahren nach einem der Ansprüche 7 bis 13, **dadurch gekennzeichnet, dass** die Filterung nach folgender Formel erhalten wird:

$$V(t0) = \max \{ V(t) : t \in (-\infty, t0) \},$$

wobei t0 der Zeitpunkt der Messung ist, wobei V(t) der Vektor ist, auf den die Filterung angewandt wird, wobei t der Zeitindex ist.

15. Verfahren nach einem der Ansprüche 7 bis 13, **dadurch gekennzeichnet, dass** die Filterung nach folgender Formel erhalten wird:

$$V(t0) = \max \{ V(t) : t \in (t0 - windowsize, t0) \},$$

wobei *windowsize* ein Zeitabschnitt des Fensters der Selbstkalibrierung ist, wobei t0 der Zeitpunkt der Messung ist, wobei V(t) der Vektor ist, auf den die Filterung angewandt wird, wobei t der Zeitindex ist.

16. Verfahren nach einem der Ansprüche 7 bis 13, **dadurch gekennzeichnet, dass** die Filterung dadurch erhalten wird, dass der Vektor, auf den die Filterung angewandt wird, durch einen vorbestimmten Vektor ersetzt wird.

17. Verfahren nach einem der Ansprüche 3 bis 16, **dadurch gekennzeichnet, dass** die Matrix M durch die Methode der partiellen kleinsten Quadrate erhalten wird, wobei der Vektor virtueller Werte ein Vektor von für idealisierte Elektroden erhaltenen Werten ist.

18. Verfahren nach einem der Ansprüche 3 bis 16, **dadurch gekennzeichnet, dass** die Matrix M anhand von Stichproben einer Wahrscheinlichkeitsdichtefunktion, die aus einer Vielzahl von exakten Positionen des Objektes in Bezug auf die Elektroden hervorgegangen ist, erhalten wird, wobei der Vektor virtueller Werte ein Vektor ist, dessen Werte Anwesenheitswahrscheinlichkeiten sind.

19. Verfahren nach Anspruch 18, **dadurch gekennzeichnet, dass** die Wahrscheinlichkeitsdichtefunktion eine um jede horizontale Objektposition zentrierte 2D-Gauß-Funktion ist, deren Breite von der vertikalen Position des Objektes abhängt, wobei diese Gauß-Funktion durch die folgende Formel definiert ist:

$$Gj(t) = A(z0) * \exp[ - ((xj - xo)^2 + (yj - yo)^2) / \sigma(zo)^2],$$

worin: (xj, yj) Koordinaten eines regelmäßigen Gitters auf einer die Elektroden umfassenden Erfassungsfläche sind; (xo(t),yo(t),zo(t) 3D-Koordinaten des der Erfassungsfläche am nächsten gelegenen Endes des Objektes sind; A(zo) und $\sigma(zo)$ zwei vorbestimmte Funktionen sind, die von dem Abstand z0 monoton abhängig sind, wobei A(z) abnehmend und $\sigma(zo)$ zunehmend ist.

20. Verfahren nach einem der vorhergehenden Ansprüche, **dadurch gekennzeichnet, dass** die Elektroden unregelmäßige Oberflächen aufweisen.

21. Elektronisches Gerät, umfassend:

   - zwei unabhängige Elektroden, die in eine Mensch-Maschine-Schnittstellenvorrichtung integriert sind,
   - eine Verarbeitungseinheit, um die Position eines Objektes durch Messen der absoluten Kapazität des Objektes in Bezug auf die Elektroden zu erfassen, **dadurch gekennzeichnet, dass** die Verarbeitungseinheit dazu ausgebildet ist, wenigstens die folgenden Schritte durchzuführen:

   a) für jede Elektrode wird ein absoluter Kapazitätswert zwischen der Elektrode und dem Objekt gemessen,
   a') durch Anwendung eines multivariaten Modells zur nichtlinearen Prädiktion auf die reellen absoluten Kapazitätswerte wird eine Vorhersage vollzogen, um ein Bild von Wahrscheinlichkeitsdichten zu erhalten, wobei diese Wahrscheinlichkeitsdichten als reelle korrigierte Werte betrachtet werden, die für die Erfassung des Objektes verwendet werden.

22. Gerät nach Anspruch 21, **dadurch gekennzeichnet, dass** das multivariate Modell zur nichtlinearen Prädiktion erhalten wird durch nichtlineare Regression aus:

   - reellen absoluten Kapazitätswerten, die für eine Vielzahl von Objektpositionen in Bezug auf die wenigstens zwei Elektroden erhalten werden, und
   - einem Wahrscheinlichkeitsdichtebild, das für eine Vielzahl von Objektpositionen in Bezug auf idealisierte Elektroden erhalten wird.

23. Gerät nach Anspruch 21 oder 22, **dadurch gekennzeichnet, dass** die Verarbeitungseinheit auch dazu ausgebildet ist, die folgenden Schritte durchzuführen:

   - bei Schritt a) wird ein Vektor $V_{raw}$ anhand der gemessenen absoluten Kapazitätswerte gebildet, und die Vorhersage bei Schritt a') umfasst die folgenden Schritte:

   b) Anwendung einer ersten nichtlinearen Transformation F2 auf wenigstens den Vektor $V_{raw}$, um einen Vektor X2 zu erhalten,
   c) Anwendung einer affinen Transformation, um einen Vektor Y2 zu erhalten, indem der Vektor X2 mit einer Matrix M2 multipliziert wird und ein Translationsvektor Y02 hinzugefügt wird; wobei die Matrix M2 eine Transfermatrix zwischen einem Vektor reeller absoluter Kapazitätswerte, die an Elektroden mit unregelmäßiger Oberfläche in Gegenwart eines Objektes erhalten werden, und einem Vektor virtueller Werte in Gegenwart eines Objektes ist,

d) Anwendung, auf wenigstens den Vektor Y2, einer zweiten nichtlinearen Transformation, die zu der ersten nichtlinearen Transformation F2 invers ist, um einen Korrekturvektor V_corr zu erhalten, und

e) Verwendung des Korrekturvektors V_corr als absolute Kapazitätswerte für die Erfassung des Objektes.

**24.** Gerät nach einem der Ansprüche 21 bis 23, **dadurch gekennzeichnet, dass** die Elektroden aus zinndotiertem Indiumoxid ausgebildet sind.

**25.** Gerät nach einem der Ansprüche 21 bis 24, **dadurch gekennzeichnet, dass** die Elektroden unregelmäßige Oberflächen aufweisen.

**Claims**

**1.** Method of measuring the absolute capacitance of an object with respect to at least two independent electrodes integrated in a human-machine interface device for the detection of said object, **characterized in that** it comprises the following steps:

a) for each electrode, a value of absolute capacitance between the electrode and the object is measured,

a') a prediction is made by applying a multi-variable nonlinear prediction model to the actual values of absolute capacitance so as to obtain an image of probability densities, these probability densities being considered as corrected absolute capacitance values that are used for the detection of said object.

**2.** Method according to claim 1, **characterized in that** the multi-variable nonlinear prediction model is obtained by nonlinear regression on the basis:

- of actual values of absolute capacitance obtained for a plurality of object positions with respect to said at least two electrodes, and

- of an image of probability densities obtained for a plurality of object positions with respect to idealized electrodes.

**3.** Method according to claim 1 or 2, **characterized in that** in step a) a vector $V_{raw}$ is constituted from the measured absolute capacitance values and the prediction in step a') comprises the following steps:

b) application of a first nonlinear transformation F2 to at least the vector $V_{raw}$ in order to obtain a vector X2,

c) application of an affine transformation in order to obtain a vector Y2 by multiplying the vector X2 by a matrix M2 and adding a translation vector Y02; the matrix M2 being a matrix of transfer between a vector of actual values of absolute capacitance obtained on electrodes of non-regular surface in the presence of an object and a vector of virtual values obtained for idealized electrodes in the presence of an object,

d) application to at least the vector Y2 of a second nonlinear transformation which is inverse to the first nonlinear transformation F2 in order to obtain a correction vector V_corr, and

e) use of the correction vector V_corr as values of absolute capacitance for the detection of said object.

**4.** Method according to claim 3, **characterized in that** the function F2 is such that $F2(V_{raw}) = 1/V_{raw}$.

**5.** Method according to claim 3, **characterized in that** the function F2 is such that $F2(V_{raw}) = 1/(V_{raw}/V_{max} + \beta)$, Vmax being a predetermined maximum voltage, and $\beta$ being a positive number.

**6.** Method according to claim 3, **characterized in that** the function F2 is such that $F2(V_{raw}) = V_{raw}/V_{max}$, Vmax being a predetermined maximum voltage.

**7.** Method according to claim 3, **characterized in that** after step a) the following steps are carried out:

- filtering of the values of the vector $V_{raw}$ in order to obtain a vector $V_{inf\_raw}$

- application of a nonlinear transformation F1 to the vector $V_{inf\_raw}$ in order to obtain a vector X1,

- application of an affine transformation in order to obtain a vector Y1 by multiplying the vector X1 by a matrix M1 and by adding a translation vector Y01; the matrix M1 being a matrix of transfer between a vector of actual values of absolute capacitance obtained on electrodes of non-regular surface in the absence of an object of detection, and a vector of virtual values in the absence of an object of detection, and

- application to the vector Y1 of a nonlinear transformation which is inverse to the nonlinear transformation F1 in order to obtain a correction vector Vinf_corr,
- then carrying out steps b) to e) in which, in step b), the nonlinear transformation F2 is applied to the vectors $V_{raw}$ and $V_{inf-raw}$ in order to obtain a vector X2 that is a function of $V_{raw}$ and $V_{inf\_raw}$; and in step d) a second nonlinear transformation, which is inverse to the first nonlinear transformation F2, is applied to the vectors Y2 and Vinf_corr in order to obtain a correction vector V_corr which is a function of Y2 and Vinf_corr.

8. Method according to claim 7, **characterized in that** the function F1 is such that $F1(V_{raw}) = 1/V_{raw}$.

9. Method according to claim 7, **characterized in that** the function F1 is such that $F1(V_{raw}) = 1/(V_{raw}/Vmax + \beta)$, Vmax being a predetermined maximum voltage, and $\beta$ being a positive number.

10. Method according to claim 7, **characterized in that** the function F1 is such that $F1(V_{raw}) = V_{raw}/Vmax$, Vmax being a predetermined maximum voltage.

11. Method according to any one of claims 7 to 10, **characterized in that** the function F2 is such that $F2(V_{raw}, V_{inf^*}) = V_{raw}/V_{inf^*}$; $V_{inf^*}$ being equal to $V_{inf\_raw}$ during the nonlinear transformation in step b), and equal to $Vinf\_corr$ during the inverse nonlinear transformation in step d).

12. Method according to any one of claims 7 to 10, **characterized in that** the function F2 is such that $F2(V_{raw}, V_{inf}^*) = 1-(V_{raw}/V_{inf^*})$; $V_{inf^*}$ being equal to $V_{inf\_raw}$ during the nonlinear transformation in step b), and equal to $V_{inf\_corr}$ during the inverse nonlinear transformation in step d).

13. Method according to any one of claims 3 to 12, **characterized in that** during step e) it comprises moreover a step of normalization of the correction vector V_corr during which the following steps are carried out:

   - filtering the correction vector V_corr in order to obtain a filtered vector V_corr_f, and
   - normalizing the correction vector with the filtered vector V_corr_f in order to obtain a normalized vector V_corr_nor.

14. Method according to any one of the claims 7 to 13, **characterized in that** the filtering is obtained according to the following formula:

   $V(t0) = \max \{ V(t): t \in (-\infty, t0) \}$; t0 being the time of the measurement, V(t) being the vector to which the filtering is applied, t being the time index.

15. Method according to any one of claims 7 to 13, **characterized in that** the filtering is obtained according to the following formula:

$$V(t0) = \max \{ V(t): t \in (t0 - windowsize, t0) \},$$

where *windowsize* is a time period of the auto-calibration window, t0 being the time of the measurement, V(t) being the vector to which the filtering is applied, t being the time index.

16. Method according to any one of claims 7 to 13, **characterized in that** the filtering is obtained by replacing the vector to which the filtering is applied by a predetermined vector.

17. Method according to any one of claims 3 to 16, **characterized in that** the matrix M is obtained by the method of partial least squares, the vector of virtual values being a vector of values obtained for idealized electrodes.

18. Method according to any one of claims 3 to 16, **characterized in that** the matrix M is obtained from a sampling of a probability density function resulting from a multitude of exact object positions with respect to the electrodes, the vector of virtual values being a vector the values of which are probabilities of presence.

**19.** Method according to claim 18, **characterized in that** the probability density function is a 2D Gaussian distribution centred on each horizontal object position, the width of which depends on the vertical position of the object, this Gaussian distribution being defined by the following formula:

$$Gj(t) = A(z0) * exp[ - ((xj - xo)^2 + (yj - yo)^2) / \sigma(z0)^2 ],$$

where: (xj,yj) are coordinates of a regular grid on a detection surface comprising the electrodes; (xo(t),yo(t),zo(t)) are 3D coordinates of the end of the object closest to the detection surface; A(zo) and $\sigma$(zo) are two predetermined functions depending on the distance z0 in a monotonic manner, A(z) being decreasing and $\sigma$(zo) increasing.

**20.** Method according to any one of the preceding claims, **characterized in that** the electrodes have non-regular surfaces.

**21.** Electronic device comprising:

- two independent electrodes integrated in a human-machine interface device
- a processing unit for detecting the position of an object by measuring the absolute capacitance of said object with respect to the electrodes, **characterized in that** the processing unit is configured to implement at least the following steps:

    a) for each electrode, a value of absolute capacitance between the electrode and the object is measured,
    a') a prediction is made by applying a multi-variable nonlinear prediction model to the actual values of absolute capacitance so as to obtain an image of probability densities, these probability densities being considered as corrected actual values that are used for the detection of said object.

**22.** Device according to claim 21, **characterized in that** the multi-variable nonlinear prediction model is obtained by nonlinear regression on the basis:

    - of actual values of absolute capacitance obtained for a plurality of object positions with respect to said at least two electrodes, and
    - of an image of probability densities obtained for a plurality of object positions with respect to idealized electrodes.

**23.** Device according to claim 21 or 22, **characterized in that** the processing unit is also configured to carry out the following steps:

    - in step a) a vector $V_{raw}$ is constituted from the measured absolute capacitance values and the prediction in step a') comprises the following steps:

        b) application of a first nonlinear transformation F2 to at least the vector $V_{raw}$ in order to obtain a vector X2,
        c) application of an affine transformation in order to obtain a vector Y2 by multiplying the vector X2 by a matrix M2 and adding a translation vector Y02; the matrix M2 being a matrix of transfer between a vector of actual values of absolute capacitance obtained on electrodes of non-regular surface in the presence of an object and a vector of virtual values obtained for idealized electrodes in the presence of an object,
        d) application to at least the vector Y2 of a second nonlinear transformation which is inverse to the first nonlinear transformation F2 in order to obtain a correction vector V_corr, and
        e) use of the correction vector V_corr as values of absolute capacitance for the detection of said object.

**24.** Device according to any one of claims 21 to 23, **characterized in that** the electrodes are designed on the basis of tin-doped indium oxide.

**25.** Device according to any one of claims 21 to 24, **characterized in that** the electrodes have non-regular surfaces.

AP

SND

SD

FIGURE 1a

VE

FAD

CT

P

CF

PT

S

E

EC

G

CDF

FIGURE 1b

FIGURE 2

FIGURE 3a

FIGURE 3b

FIGURE 4

FIGURE 5a

FIGURE 5b

FIGURE 6

FIGURE 7a

FIGURE 7b

FIGURE 8

FIGURE 9

**EP 2 724 216 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2844349, Rozière
- US 6348862 B1
- US 20030132922 A
- US 20100013800 A
- WO 2011015795 A1
- WO 2011015795 A
- FR 1059203